# EUROPEAN PATENT APPLICATION

(11) **EP 4 697 925 A1**
(43) Date of publication of application: **18.02.2026**
(21) Application number: 25190874.5
(22) Date of filing: 22.07.2025
(51) Int. Cl.: H10W 95/00, B81B 7/00, H10W 76/12, H10W 76/47, H10W 74/10

(54) **STRUCTURE AND METHOD TO CREATE A PORT ON THE EDGE OF A PRESSURE SENSOR PACKAGE**

(30) Priority: 26.07.2024 US 202418786343
(71) Applicant: NXP USA, Inc., Austin, TX 78735 (US)
(72) Inventor: Daniels, Dwight Lee, 5656AG Eindhoven (NL)
(74) Representative: Colaiuda, Antonella

(57) **Abstract**

A semiconductor device may include a semiconductor die mounted on a substrate. A semiconductor device may include a body portion of a semiconductor package including a plurality of walls configured to define a cavity. A semiconductor device may include a package lid having a plurality of channels formed in a bottom surface of the package lid and the bottom surface of the package lid is mounted to a top surface of the body portion of the semiconductor package. A semiconductor device may include a vent or a plurality of vents that exposes the cavity of the semiconductor package to ambient air and other media exterior the semiconductor package.

## Description

### TECHNICAL FIELD

Embodiments of the subject matter described herein relate generally to semiconductor packaging, and more particularly, embodiments of the subject matter relate to improved packaging for pressure sensors.

### BACKGROUND

The present disclosure relates generally to semiconductor packages, and, more specifically to semiconductor sensor packages, such as packages including pressure sensor devices. Semiconductor sensor devices, such as pressure sensors, are well known. These devices use pressure sensor dies to sense ambient air pressure and other media. These dies are packaged and protected, but still require that there is a vent or vents in the package to form a pathway to allow these media to pass through the package housing and be sensed, often at some interior cavity through a pressure sensitive gel. In conventional devices, such package vents can allow contaminants to enter the central cavity of the package, which can sometimes impede the function of the sensitive semiconductor dies within the package.

### BRIEF DESCRIPTION OF THE DRAWINGS

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.
FIG. 1 shows a cross-sectional side view of a typical semiconductor package.
FIG. 2 shows a semiconductor package in accordance with the present disclosure.
FIG. 3 shows a cross-sectional side view of the semiconductor package of FIG. 2 in accordance with the present disclosure, wherein channels are formed in a bottom surface of a lid.
Fig. 4A shows a bottom perspective view of the channels formed in the bottom surface of the semiconductor package lid of FIG. 3.
FIG. 4B shows a bottom perspective view of channels formed in a bottom surface of a semiconductor package in which the channels are oriented in multiple directions.
FIG. 5 shows a cross-sectional side view of an alternative embodiment of a semiconductor package in accordance with the present disclosure, wherein channels are formed in a top surface of a body portion of the semiconductor package.
FIG. 6A shows a top view of the channels formed in the top surface of the body of the semiconductor package of FIG. 5.
FIG. 6B shows a top view of channels formed in a top surface of a body of an alternative embodiment of a semiconductor package.
FIG. 7 shows a cross-sectional side view of an alternative embodiment of a semiconductor package in accordance with the present disclosure, wherein channels are formed in a top surface of a body of the semiconductor package and a bottom surface of a lid.
FIG. 8 shows a view of various channel cross-sectional shapes that can be formed according to various embodiments.
Fig. 9A-9F shows a cross-sectional side view of a packaging process of the semiconductor package of FIG. 3 in accordance with the present disclosure.

### DETAILED DESCRIPTION

It will be readily understood that the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

Embodiments of this disclosure may present in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

For simplicity, the described features, advantages, and characteristics of the invention are described throughout this specification may be described as being implemented within an embedded device, semiconductor device or package, microelectronic device, etc., including one or more microprocessors, other processing units, programmable and/or non-programmable memory, and other integrated circuits as well as individual circuit components and other pieces of electronic equipment, but the present devices and methods may be implemented in other electronic devices for which the described package designs, systems, and methods of manufacture would be useful.

In general, the embodiments described herein provide for the manufacture of semiconductor sensor devices and semiconductor packages that include a vent or plurality of vents that may be formed within a surface of the package to enable airflow between an interior cavity of a package to the ambient air or other media exterior the package. In various embodiments, channels may be formed in either a bottom surface of the semiconductor package's lid, a top surface of the body of the package, or a combination thereof. The channels can be configured so that when the package lid is mounted to the package body, following the formation of the channels, the channels form vents that penetrate through one or more of the sides of the package, enabling fluid communication, such as air flow, between an interior volume in a cavity of the package and the exterior of the package.

The package in these embodiments may be a cavity package or other sensor packaging design having a cavity that can contain semiconductor die, such as a pressure transducer. The semiconductor die can be protected within the cavity by a pressure sensitive gel that is disposed within the cavity and over the semiconductor die. The pressure sensitive gel can be soft enough to deform based on the pressure applied to the gel inside the cavity and which can be transferred to the semiconductor die the gel is disposed over. Additionally, the pressure sensitive gel can act as a protectant to the sensitive portions of the semiconductor die that it covers. The vent or plurality of vents can be formed through the side of the package and can enable ambient air to access the cavity of the package through the vent or vents, enabling proper operation of a pressure sensing semiconductor die within the package. At the same time, and in contrast to conventional packages, the placement of the one or more vents on the sides of the device package can reduce the probability of contaminants entering the cavity through the pathway. In addition, vents formed in the sides of the package can enable the implementation of a semiconductor package having a greater number of vents at a smaller size. When compared to a semiconductor package having one vent, the package comprising multiple vents can have greater resiliency to being plugged by contamination which can stop the flow of ambient air to the package cavity.

The channels that are the subject of this disclosure may be formed in the lid or the body of the package and are found at the mating surface of the lid and body of the package. When channels are formed in both the lid and the body of the package, the channels can be aligned or nonaligned with respect to each other when the lid is mounted to the body. The channels can be formed using any suitable methods including known methods such as molding, stamping and sawing, as nonlimiting examples. Channels, according to one or more embodiments, can be formed before adhering the body of the package to the lid of the package using any of the methods described. The channels of the various embodiments may be variable in length, width, shape and in number and are not restricted to any one application. When formed in the lid, the channels can run the entire length of the package lid or may instead be shortened while meeting a minimum channel length requirement that is selected to ensure sufficient overlap with the cavity containing the semiconductor die within the package as needed to provide adequate package venting. When the channels are formed in the package body, they can run from the exterior of the package to the cavity.

Channels can be formed in the lid or body portion during the packaging process and may be molded, stamped, or sawn from the encapsulant. The channels can also be formed prior to the packaging process, and according to an exemplary embodiment, can be a preformed piece of the package. This can be done prior to the attachment of the lid to the body of the package. After the channels are formed, adhesive can be dispensed around the perimeter edge of the body portion of the package in areas where channels have not been formed. The lid can then be placed down over the body and cavity of the package and mounted via the adhesive. Adhesive may, in some embodiments, fill some portion of the plurality of channels near the location where the adhesive is placed and act as a mechanical lock to further secure the lid to the body of the package. Wherein, at least one of the plurality of channels can remain free of the adhesive in order to maintain the functionality of the device.

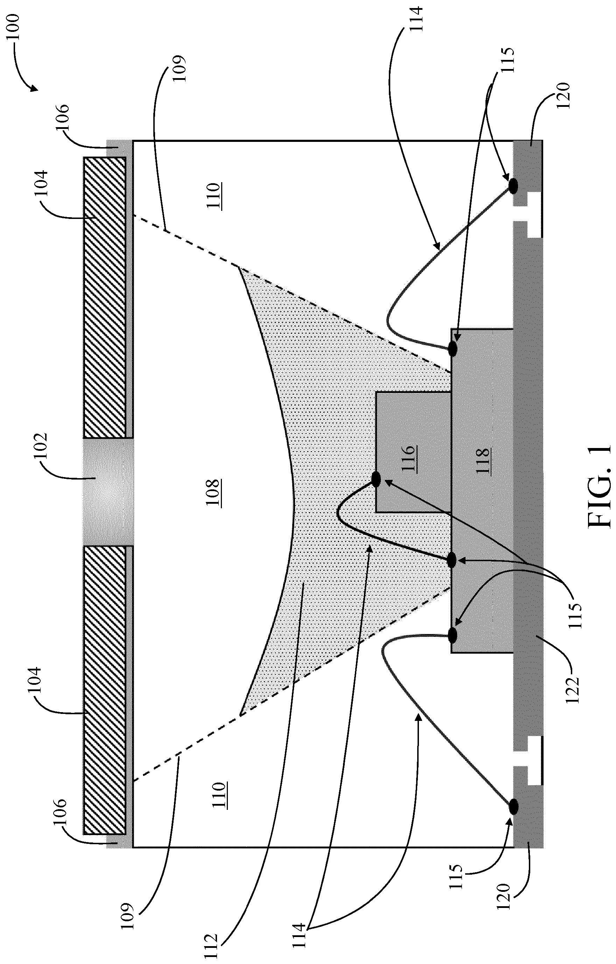

FIG. 1 shows a cross-sectional side view of a semiconductor package 100. A first semiconductor die 118 is mounted on a substrate 122 and a second semiconductor die 116, such as a pressure transducer, is mounted to the first semiconductor die 118. Circuit components contained within the second semiconductor die 116 may have metal traces for components interconnects such as bond pads 115 and can be electrically connected to circuit components contained within the first semiconductor die 118 having bond pads 115 via bond wires 114 to enable the functionality of both components. Circuit components contained within the first semiconductor die 118 can be connected at bond pads 115 via bond wires 114 to the lead frame leads 120. Lead frame leads 120 may then be connected to other components and devices within a larger system. For example, if semiconductor package 100 were a pressure sensor device in an automotive setting, then ambient air pressure data could be provided to a system controller as electrical signals through the lead frame leads 120.

A body portion 110 of the semiconductor package 100 is formed as a plurality of walls 109 and encapsulates the lead frame leads 120 and substrate 122, as well as partially encapsulates first semiconductor die 118. The plurality of walls 109 of the body portion 110 of the semiconductor package 100 define a cavity 108 within the semiconductor. A portion of the cavity 108 is filled with a pressure sensitive gel 112, that is disposed to cover the second semiconductor die 116 and a portion of the first semiconductor die 118. The cavity 108 is exposed to ambient air and other media through a vent 102 through a lid 104 at a top surface of the semiconductor package 100. The lid 104 is attached to the body portion 110 through adhesive 106.

Having the vent 102 at the top of the semiconductor package 100 can cause infiltration and contamination issues that can damage and impede the accuracy of the device contained within. Because there are practical limitations to the size of the vent 102, the vent 102 is large enough that debris and contaminants can enter through the vent 102 and contaminate the pressure sensitive gel 112. Additionally, because of the size and location of the vent 102 tweezers and other tooling can enter through the vent 102 and damage or destroy the pressure sensitive gel 112, bond wires 114 or the semiconductor dies contained within the cavity 108.

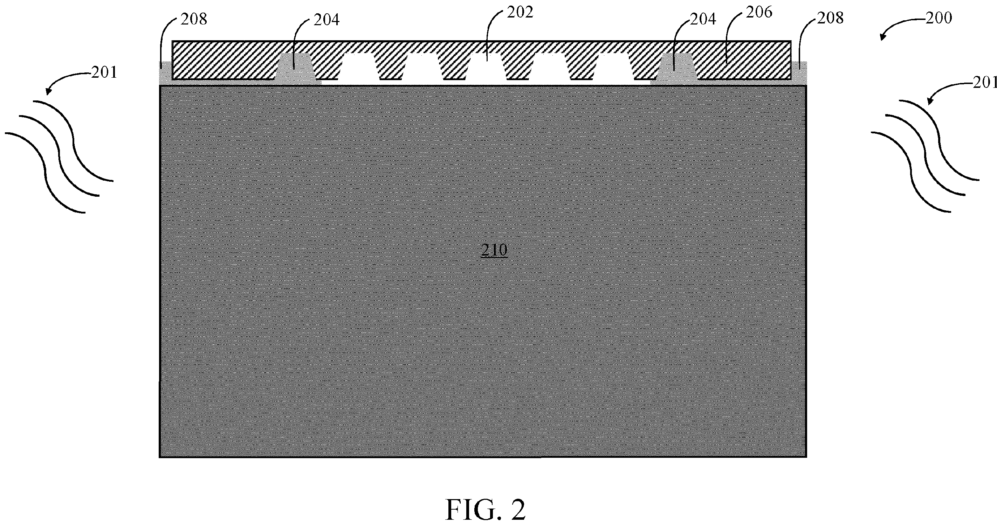

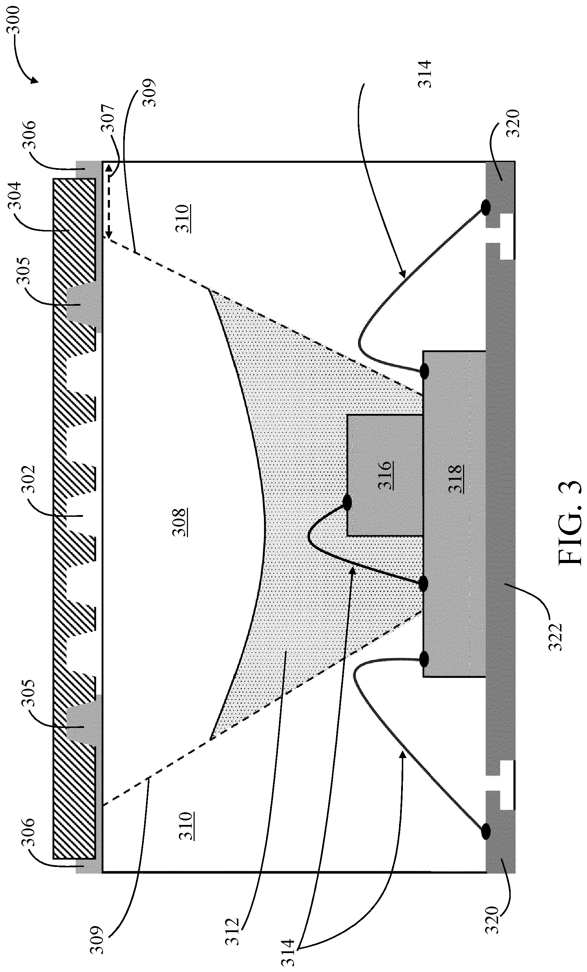

To mitigate these problems associated with device 100 of FIG. 1, an improved package design is provided in which package vents are formed by one or more channels defined in one or more side surfaces of the device. To illustrate, FIG. 2 and FIG. 3 show an exemplary of package 200 in accordance with the present disclosure. FIG. 2 shows a side view of the exterior of a semiconductor package 200 while FIG. 3 shows a cross-sectional side view of the same semiconductor package as shown in FIG. 2. While FIG. 2 is intended to demonstrate how the exterior of the package would appear according to this embodiment, it should be understood that it is not limited to only this embodiment and applies generally throughout the disclosure and various embodiment therein. Although semiconductor package 200 is depicted as a cavity package, in should be understood that embodiments of the present package are not limited to cavity packages and may be implemented in conjunction with other package types. Exterior to the semiconductor package 200 ambient air 201 is depicted. Ambient air 201 is an example media that may be found exterior the semiconductor package 200, however that media may also be various forms of air and gas and liquids that can be in a pressurized or non-pressurized environment.

The semiconductor package includes a body portion 210 which is formed around semiconductor die within the interior of the package. The body portion 210 may be formed from a mold compound, epoxy resin, or any other die encapsulant material. A lid 206 is shown mounted at a top surface of the body portion 210 using an adhesive 208.

The lid 206 includes a plurality of vents 202 which are formed prior to the mounting of the lid 206 to the body portion 210 of the semiconductor package 200. The plurality of vents 202 may be formed as channels by molding, stamping or sawing the desired shapes into the lid 206. The formation of the channels is not limited to these methods and may be formed by any other means known to one having ordinary skill in the art.

With the channels formed in lid 206, lid 206 can be mounted on the body portion 210 of the semiconductor package 200 using adhesive 208 to form the plurality of vents 202. Other techniques may also be used to mount the lid 206 to the body portion 200. For example, epoxy underfill, soldering, compression bonding, ultrasonic bonding and mechanical fasteners are all non-limiting techniques that may be used for mounting. The adhesive 208 may be dispensed according to this exemplary embodiment to fill a portion of the plurality of vents 202 when the lid 206 is mounted to the body portion 210 in order to create a mechanical lock 204 and further strengthen the adhesion of lid 206 to the body portion 210 of the semiconductor package 200. The adhesive 208 may also be dispensed in a manner that prevents the adhesive 208 from filling a portion of the plurality of vents 202 according to some embodiments of the present disclosure.

The plurality of vents 202 are depicted on a single side of the semiconductor package 200. Accordingly, one embodiment of the present disclosure considers that the plurality of vents 202 may be formed in one side of the semiconductor package 200 only. Another embodiment considers that the plurality of vents 202 may be formed in all sides of the semiconductor package 200. Another embodiment considers that the plurality of vents 202 may be formed in a portion of the sides of the semiconductor package 200.

FIG. 3 shows a cross-sectional side view of the semiconductor package 300 of FIG. 2 in accordance with the present disclosure, wherein a plurality of vents 302 are formed in a bottom surface of a lid 304. A first semiconductor die 318 is mounted on a substrate 322 and a second semiconductor die 316, such as a pressure transducer, is mounted to the first semiconductor die 318. Two die are shown in the various embodiments, but the invention is applicable to any semiconductor sensor structure having any number of die. For example, the second semiconductor die 316, if it were a pressure transducer, could be an on-die pressure transducer on the first semiconductor die 318, wherein that embodiment would have a single semiconductor die. Conversely, there are one or more embodiments that contain more than two semiconductor die or components. Bond wires 314 are used to electrically connect the second semiconductor die 316 to the first semiconductor die 318 and the first semiconductor die 318 to lead frame leads 320. A body portion 310 of the semiconductor package 300 is formed as a plurality of walls 309 and encapsulates the lead frame leads 320 and the substrate 322, as well as partially encapsulates the first semiconductor die 318. The plurality of walls 309 of the body portion 310 of the semiconductor package 300 defines a cavity 308 within the semiconductor. A portion of the cavity 308 is filled with a pressure sensitive gel 312, that is disposed to cover the second semiconductor die 316 and a portion of the first semiconductor die 318. The cavity 308 is exposed to ambient air and other media through the plurality of vents 302 that were formed as channels in the bottom portion of the lid 304 before the lid was mounted to the top surface of the body portion 310. The lid 304 is mounted to the top surface of the body portion 310 using an adhesive 306. The adhesive 306 may fill a portion of the plurality of vents 302 that may be used as mechanical locks 305 to strengthen the adhesion of the lid 304 to the body portion 310 of the semiconductor package 300.

The plurality of vents 302 of this embodiment are formed in the bottom surface of the lid 304 after it is mounted to the top surface of the body portion 310. Before the lid 304 is mounted to the top surface of the body portion 310 channels are formed in the bottom surface of the lid 304. These channels may be formed by molding, stamping, sawing or any other method known by one of ordinary skill in the art to a predetermined size and shape. The channels size and number formed can be based on a desired sum of the cross-sectional area of the plurality of vents 302. Contamination can sometimes plug a portion of the plurality of vents 302 and therefore having more than one vent can help to prevent a total loss of ambient airflow or other fluid communication happening through one or more of the plurality of vents 302.

When the channels are formed in the body portion 310, then they can have a length equal to the thickness of the top surface 307 of the wall of the body portion 310 of the package. The lid 304 can then be mounted to the top surface of the body portion 310 after the formation of the channels, the plurality of vents 302 then forms a pathway that can allow ambient air and other media from an exterior of the package to the cavity 308 at the interior of the semiconductor package 300.

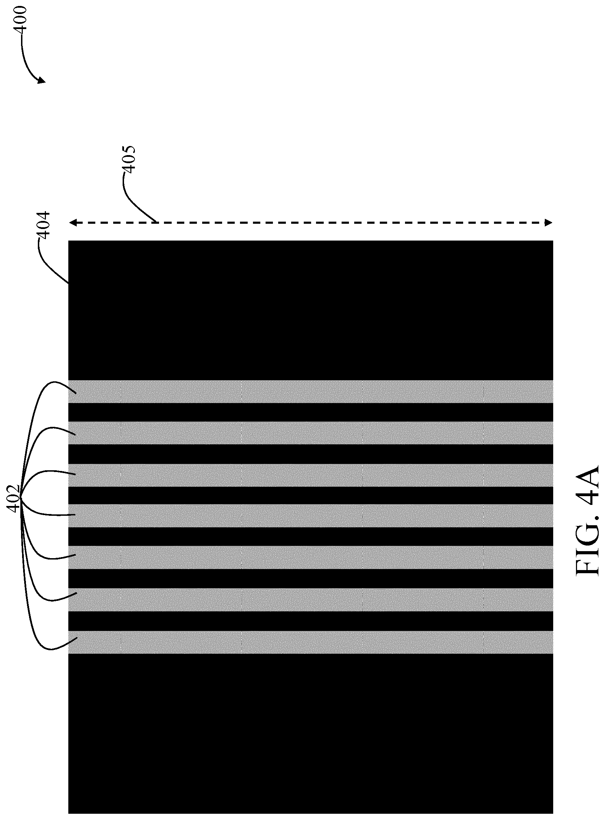

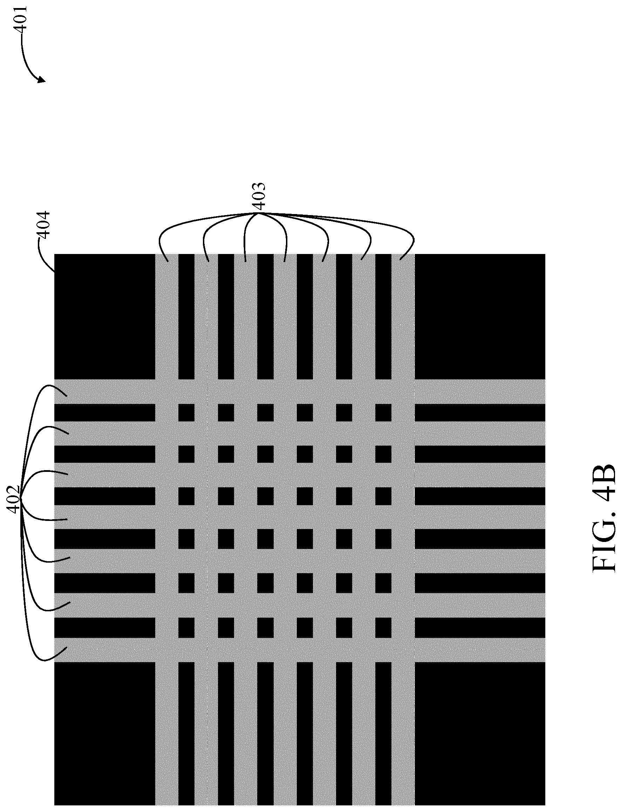

FIG. 4A and 4B are exemplary embodiments of a lid 404 (e.g., lid 304 of FIG. 3). The figures are a bottom-up view showing the bottom surface of a lid and demonstrating the portion of the lid 304 where channels have been formed therein.

FIG. 4A depicts an exemplary embodiment of the bottom surface of the lid 304 of FIG. 3 wherein a first plurality of channels 402 are formed in the bottom surface of the lid 400. The first plurality of channels 402 of the embodiment may be formed parallel to one another in a latitudinal direction and can be equal length to the lid 400 in which they are formed. This length is shown in FIG. 4A and is depicted by the dashed line 405. However, the first plurality of channels 402 may also be formed to follow any axis and can be parallel to one another or intersect one another. Seven channels are demonstrated in the embodiment shown in FIG. 4A, however, any number of channels of various sizes and shapes may be formed in the lid 400. The first plurality of channels 402 may be formed by molding, stamping, or sawing them during the formation process of the lid 400. However, any other method known to one of ordinary skill in the art may be used to form the first plurality of channels 402 in the lid 400.

Although the first plurality of channels 402 of the exemplary embodiment of FIG. 4A are equal in length to the lid 400, they may be formed to some lesser length according to other embodiments of the present disclosure. For example, when the semiconductor package is a cavity package such as the embodiment shown in FIG. 3, the first plurality of channels 402 may need only be formed to be a length greater than at least one of the plurality of walls 309 of the body portion 310 of the semiconductor package 300. The purpose of the first plurality of channels 402 is to allow ambient air or some other form of media to be able to enter a cavity, such as the cavity 308 of FIG. 3, to enter through vents that are formed when the lid 400 having the first plurality of channels 402 is mounted to a semiconductor package such as the one seen in FIG. 3. This purpose may be accomplished by forming the first plurality of channels 402 to be the length of the lid 400 itself or any lesser length that still allows a vent to be formed when the lid 400 is mounted on various semiconductor packages.

FIG. 4B depicts an exemplary embodiment of the bottom surface of the lid 304 from FIG. 3 wherein a first plurality of channels 402 and a second plurality of channels 403 are formed in the bottom surface of a lid 401. The first plurality of channels 402 may be formed parallel to one another in a latitudinal direction and can be equal length to the lid 401 in which they are formed. However, the first plurality of channels 402 may also be formed to follow any axis and can be parallel to one another or intersect on another. The second plurality of channels 403 may be formed parallel to one another in a longitudinal direction and can be equal in length to the lid 401 in which they are formed. However, the second plurality of channels 403 may be formed to follow any axis and can be parallel to one another or intersect one another. Seven channels are demonstrated in the embodiment shown in FIG. 4A, however, any number of channels of various sizes and shapes may be formed in the lid 400. The first plurality of channels 402 and the second plurality of channels 403 may be formed by molding, stamping or sawing them during the formation process of the lid 400. However, any other method known to one of ordinary skill in the art may be used to form the first plurality of channels 402 and the second plurality of channels 403 in the lid 401.

Although the first plurality of channels 402 and the second plurality of channels 403 of the exemplary embodiment of FIG. 4A are equal in length to the lid 400, they may be formed to some lesser length according to other embodiments of the present disclosure. For example, when the semiconductor package is a cavity package such as the embodiment shown in FIG. 3, the first plurality of channels 402 and the second plurality of channels 403 need only be formed to be a length greater than the thickness of the top surface of the body portion 310 of the semiconductor package 300 of FIG. 3. The purpose of the first plurality of channels 402 and the second plurality of channels 403 is to allow ambient air or some other form of media to be able to enter a cavity, such as the cavity 308 of FIG. 3, through vents that are formed when the lid 401 having the first plurality of channels 402 and the second plurality of channels 403 are mounted to a semiconductor package 300 such as the one seen in FIG. 3. This purpose may be accomplished by forming the first plurality of channels 402 and the second plurality of channels 403 to be the length of the lid 401 itself or any lesser length that still allows a vent to be formed when the lid 401 is mounted on various semiconductor packages.

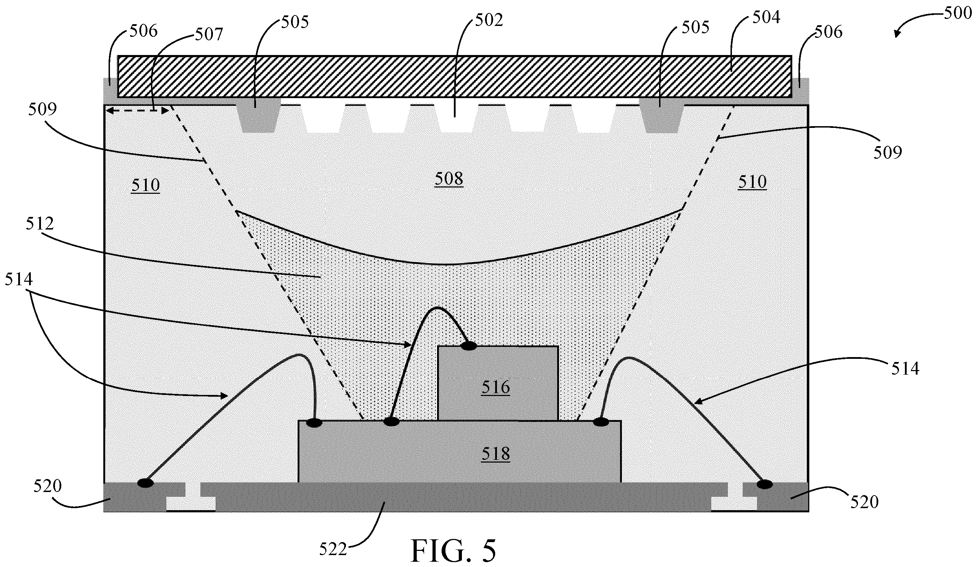

FIG. 5 shows a cross-sectional side view of an alternative embodiment of a semiconductor package 500 in accordance with the present disclosure, wherein a plurality of vents 502 are formed in a top surface of a body portion 510 of the semiconductor package 500. A semiconductor die 518 is mounted on a substrate 522 and a second semiconductor die 516, such as a pressure transducer, is mounted to the semiconductor die 518. Bond wires 514 are used to electrically connect the second semiconductor die 516 to semiconductor die 518 and semiconductor die 518 to the lead frame leads 520. The body portion 510 of the semiconductor package 500 is formed as a plurality of walls 509 and encapsulates the lead frame leads 520 and substrate 522, as well as partially encapsulates semiconductor die 518. The plurality of walls 509 of the body portion 510 of the semiconductor package 500 defines a cavity 508. A portion of the cavity 508 is filled with a pressure sensitive gel 512, that is disposed to cover the second semiconductor die 516 and a portion of the semiconductor die 518. The cavity 508 is exposed to ambient air and other media through the plurality of vents 502 that were formed as channels in the top surface of the body portion 510 of the semiconductor package 500 when the lid 504 was mounted to the top surface of the body portion 510. The lid 504 is mounted to the top surface of the body portion 510 using an adhesive 506. The adhesive 506 may fill a portion of the plurality of vents 502 that may be used as mechanical locks 505 to strengthen the adhesion of the lid 504 to the body portion 510 of the semiconductor package 500.

The plurality of vents 502 of this embodiment are formed in the top surface of the plurality of walls 509 of the body portion 510 of the semiconductor package 500. Before the lid 504 is mounted to the top surface of the body portion 510 channels are formed in the top surface of the body portion 510. These channels may be formed by molding, stamping, sawing or any other method known by one of ordinary skill in the art to any size or shape. When the channels are formed in the body portion 510, then they will have a length equal to the thickness of the body portion wall at that top surface as shown by the dashed line 507. When the lid 504 is then mounted to the top surface of the body portion 510 after the formation of the channels, the plurality of vents 502 then forms a pathway that can allow ambient air and other media from an exterior of the package to the cavity 508 at the interior of the semiconductor package 500.

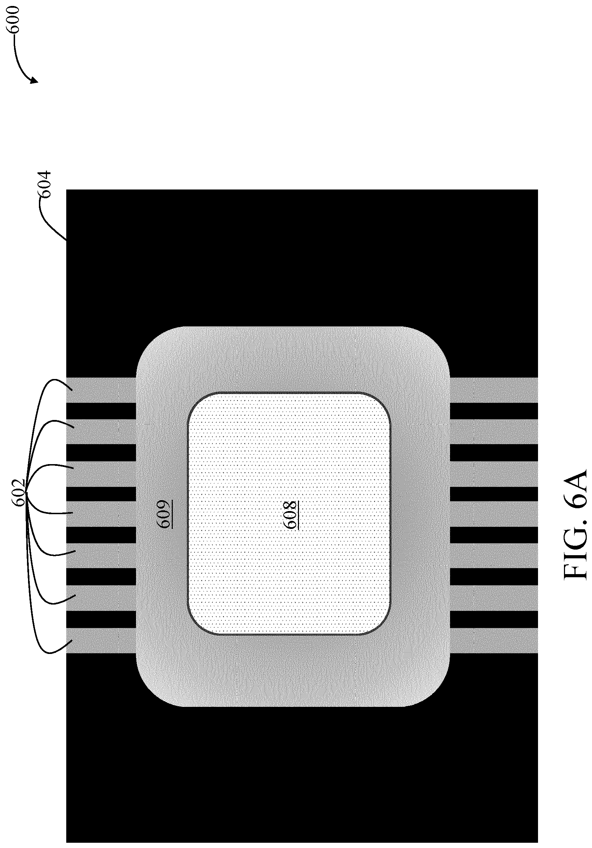

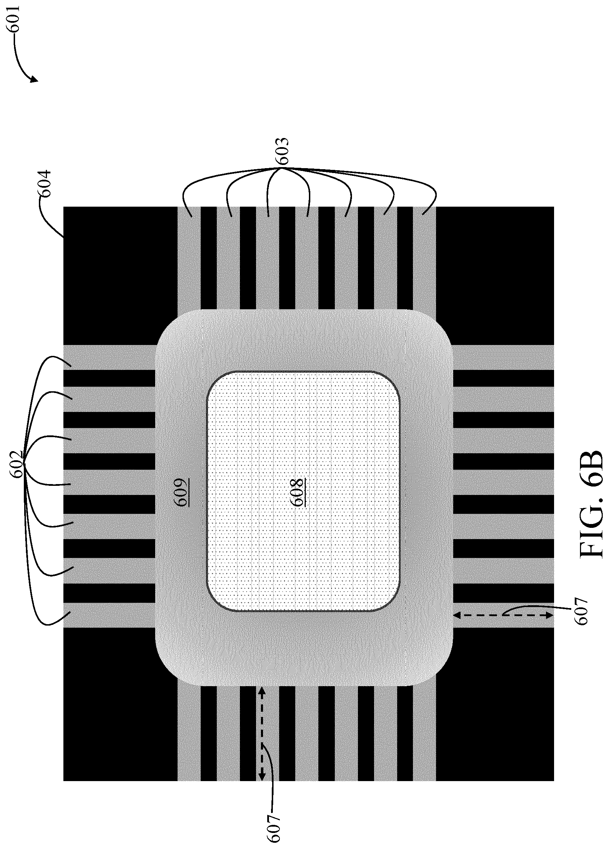

FIG. 6A and 6B are exemplary embodiments of the semiconductor package 500 from FIG. 5. The figures are a top-down view showing the semiconductor package 500 as if the lid 504 were removed and the top surface of the body portion 510 and the cavity 508 were visible.

FIG. 6A depicts an exemplary embodiment of the semiconductor package 500 of FIG. 5 having the lid 504 removed and showing a top surface of a body portion 604 having a plurality of channels 602 formed therein. Further defining the body portion 604 is a plurality of walls 609 that define a cavity within the body portion 604 of a semiconductor package 600. A pressure sensitive gel 608 is disposed within the cavity.

The plurality of channels 602 of the embodiment may be formed parallel to one another in a latitudinal direction and can be equal in length to the thickness of the top surface of the body portion as defined by the length between the exterior of the package and the interior at the plurality of walls 609. However, the plurality of channels 602 may be formed to follow any axis and can be parallel to one another or intersect on another. Seven channels are demonstrated in the embodiment shown in FIG. 6A, however, any number of channels of various sizes and shapes may be formed in the top surface of the body portion 604. The plurality of channels 602 may be formed by molding, stamping, or sawing them during the formation process of the body portion 604. However, any other method known to one of ordinary skill in the art may be used to form the plurality of channels 602 in the body portion 604.

FIG. 6B depicts an exemplary embodiment of the semiconductor package 500 of FIG. 5 having the lid 504 removed and showing a top surface of a body portion 604 having a plurality of channels 602 and a second plurality of channels 603 formed therein. Further defining the body portion 604 is a plurality of walls 609 and that define a cavity within the body portion 604 of a semiconductor package 601. A pressure sensitive gel 608 is disposed within the cavity.

The plurality of channels 602 and the second plurality of channels 603 of the embodiment may be formed parallel to one another in a latitudinal direction and can be equal in length to the thickness of the top surface of the body portion as defined by the length between the exterior of the package and the interior at the plurality of walls 609. This length is depicted in FIG. 6B using the dashed lines 607. However, the plurality of channels 602 may be formed to follow any axis and can be parallel to one another or intersect on another. Seven latitudinal channels and seven longitudinal channels are demonstrated in the embodiment shown in FIG. 6B, however, any number of channels of various sizes and shapes may be formed in the top surface of the body portion 604. The plurality of channels 602 and the second plurality of channels 603 may be formed by molding, stamping, or sawing them during the formation process of the body portion 604. However, any other method known to one of ordinary skill in the art may be used to form the plurality of channels 602 and the second plurality of channels 603 in the body portion 604.

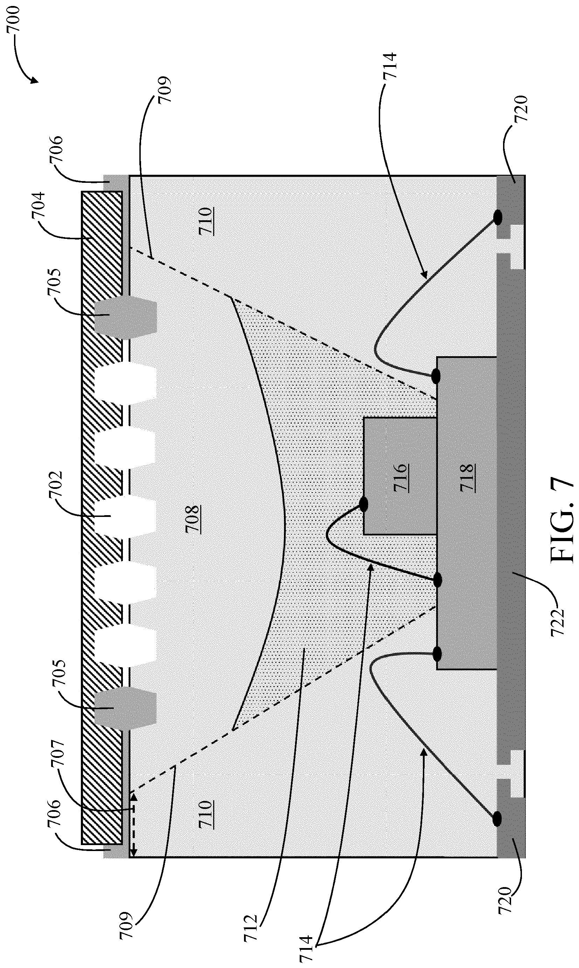

FIG. 7 shows a cross-sectional side view of an alternative embodiment of a semiconductor package 700 in accordance with the present disclosure, wherein a plurality of vents 702 are formed in a top surface of a body portion 710 of the semiconductor package 700 and a bottom surface of a lid 704. A first semiconductor die 718 is mounted on a substrate 722 and a second semiconductor die 716, such as a pressure transducer, is mounted to the first semiconductor die 718. Bond wires 714 are used to electrically connect the second semiconductor die 716 to first semiconductor die 718 and first semiconductor die 718 to lead frame leads 720. The body portion 710 of the semiconductor package 700 is formed as a plurality of walls 709 and encapsulates the lead frame leads 720 and substrate 722, as well as partially encapsulates first semiconductor die 718. The plurality of walls 709 of the body portion 710 of the semiconductor package 700 defines a cavity 708. A portion of the cavity 708 is filled with a pressure sensitive gel 712, that is disposed to cover the second semiconductor die 716 and a portion of the first semiconductor die 718. The cavity 708 is exposed to ambient air and other media through the plurality of vents 702 that were formed as channels in the top surface of the body portion 710 of the semiconductor package 700 the lid 704 was mounted to the top surface of the body portion 710. The lid 704 is mounted to the top surface of the body portion 710 using an adhesive 706. The adhesive 706 may fill a portion of the plurality of vents 702 that may be used as mechanical locks 705 to strengthen the adhesion of the lid 704 to the body portion 710 of the semiconductor package 700.

The plurality of vents 702 of this embodiment are formed in the top surface of the body portion 510 of the semiconductor package 500 and in the bottom surface of the lid 704. Before the lid 704 is mounted to the top surface of the body portion 710 channels are formed in the top surface of the body portion 510 and in the bottom surface of the lid 704. These channels may be formed by molding, stamping, sawing, or any other method known by one of ordinary skill in the art, to any size or shape.

When the channels are formed in the body portion 710, they will have a length equal to the thickness of the body portion 710 at a top surface. This length is depicted in FIG. 7 using a dashed line 707. When the channels are formed in the lid 704 they may be formed to be of any length equal to or greater than the thickness of the body portion 710 at a top surface which is the length depicted by the dashed line 707. When the lid 704 is then mounted to the top surface of the body portion 710 after the formation of the channels, the plurality of vents 702 then forms a pathway that can allow ambient air and other media from an exterior of the package to the cavity 708 at the interior of the semiconductor package 700.

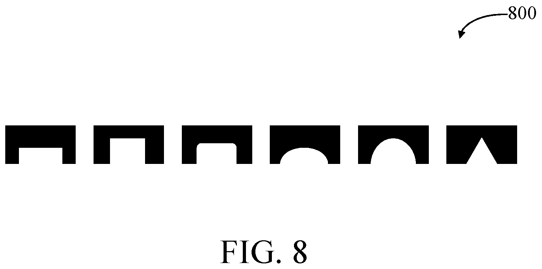

FIG. 8 shows a view of various channel cross-sectional shapes that can be formed according to various embodiments. Channels 800 may be formed by molding, stamping, sawing, or any other method of formation known by one of ordinary skill in the art. The shape and size of the channels 800 can be determined based on the intended use of the semiconductor package they will be used in. The channel's shape for example may be chosen based on the expected media and contaminates that the package may encounter. Shape may also be determined based on the method chosen to form the channels.

Another factor that may be considered is the sum of the cross-sectional area of the formed channels. For example, to ensure that sufficient ambient air or other media have access to an interior of a package, a total cross-sectional area requirement can be determined for the channels 800. To achieve this, the number of channels 800 and size of channels 800 to be formed can be determined and sized according to this cross-sectional area requirement.

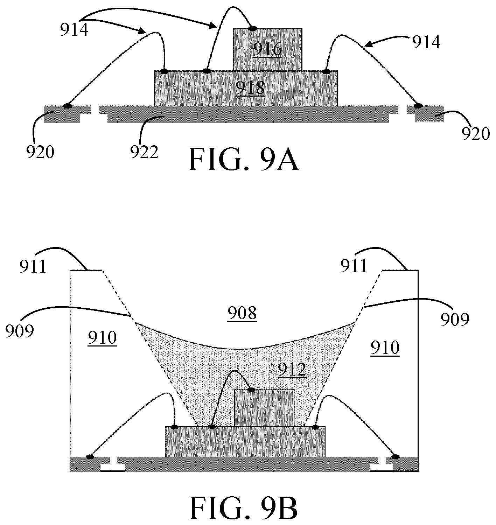

Fig. 9A-9F shows a cross-sectional side view of a packaging process of the semiconductor package 300 of FIG. 3 in accordance with the present disclosure.

FIG. 9A illustrates a conventional semiconductor device, such as a pressure sensor, having a first semiconductor die 918 mounted on a substrate 922. Bond wires 914 can be used to electrically connect the first semiconductor die 918 to lead frame leads 920.

FIG. 9B illustrates the step of forming the body portion 910 of a semiconductor package according to the present disclosure. The body portion 910 may be formed from a mold compound or any other method to encapsulate the lead frame leads 920, substrate 922 and partially encapsulate the first semiconductor die 918. A second semiconductor die 916 can be mounted on top of the first semiconductor die 918 having wire bonds 914 to electrically connect the second semiconductor die 916 to the first semiconductor die 918. A plurality of walls 909 will be formed on the interior of the body portion 910 and define a cavity 908. Inside of the cavity 908, a portion is filled by a pressure sensitive gel 912 over the second semiconductor die 916 and a portion of the first semiconductor die 918.

A top surface 911 of the body portion 910 in this embodiment can be a planar surface. The top surface 911 is the region between the exterior perimeter of the semiconductor package 900 and the interior edge at a plurality of walls 909. When formed without any channels, then the region can be considered a planar surface. Other embodiments of the present disclosure consider channels formed in the top surface 911 and would consider the surface in those embodiments non-planar.

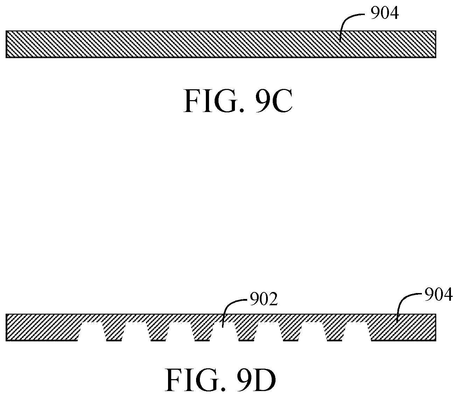

FIG. 9C illustrates the optional step of forming the lid 904 that may be formed from ceramic, metal, glass, or any other known packaging material. The bottom surface of the lid may be substantially planar at the time of formation.

FIG. 9D illustrates the step of forming a plurality of channels 902 in the lid 904. The plurality of channels 902 may be formed by molding, stamping, sawing or any other method known by one of ordinary skill in the art. The plurality of channels 902 may be formed to take any shape or size depending on the desired application and are formed prior to the lid 904 being mounted to the semiconductor package. Wherein, the lid 904, before the plurality of channels 902 can be formed therein, the bottom surface of the lid 904 may be a planar surface. After the plurality of channels 902 can be formed in the lid, the bottom surface of the lid may be a non-planar surface.

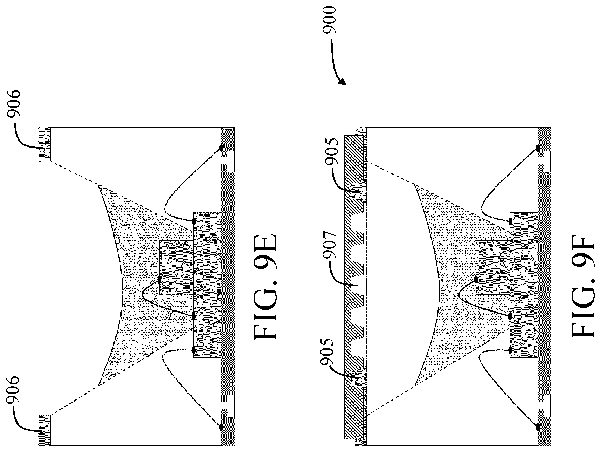

FIG. 9E illustrates the step of dispensing an adhesive 906 on the top surface of the body portion 910. Adhesive 906 can be dispensed as a bead around an entire perimeter of the top surface of the body portion 910 or it can be strategically dispensed on portions of the top surface of the body portion 910 that align with areas of the lid 904 where no channels are formed when mounted to the body portion 910. Alternatively, the adhesive 906 can be dispensed in areas that when mounted have a portion of the plurality of channels 902 and where the adhesive fills that portion of the channels acting as a mechanical lock 905 for the lid 904 adhesion. This reinforces the bond between the lid 904 and the body portion 910 and reduces the variability in lid 904 placement on the body portion 910. In sum, adhesive 906 for mounting the lid 904 may be dispensed in a manner that leaves all the plurality of channels 902 free of adhesive or dispensed in a manner that allows for a portion of the plurality of channels 902 to be filled with adhesive. The adhesive 906 may be any suitable lid-attach adhesive, such as an epoxy or silicon adhesive.

FIG. 9F illustrates the step of mounting the lid 904 to the top surface of the body portion 910 via the adhesive 906 and demonstrates the mechanical lock 905 where a channel has been filled with adhesive 906. Once the lid 904 is mounted, a plurality of vents 907 are now formed in the side of a semiconductor package 900. The plurality of vents 907 form a pathway for ambient air and other media to have fluid communication between an exterior of the package and the cavity 908 that is defined within the semiconductor package 900. For example, if the package was for a pressure sensor device, then the plurality of vents 907 would form a pressure pathway for the ambient pressure to be capable of equalizing with the pressure within the cavity and to be read by the device through the pressure sensitive gel 912.

FIGS. 9A-9F are demonstrative of an embodiment of the present disclosure where the vents are formed in the lid of the semiconductor package but it should be understood that the exemplary method would also apply to an embodiment where the vents are formed in the body of the semiconductor package or in a combination of the lid and body. The process is not intended to limit its implementation to those embodiments or any other embodiment within the scope of the present invention.

In some aspects, the techniques described herein relate to a method of manufacturing a semiconductor package, including: mounting a semiconductor die to a substrate; forming encapsulant over the substrate to form a body portion of the semiconductor package, wherein the body portion includes a plurality of walls defining a cavity; providing a package lid, wherein the package lid includes a first channel or a first plurality of channels formed in a bottom surface of the package lid; and mounting the bottom surface of the package lid to a top surface of the plurality of walls of the body portion, wherein the first channel or the first plurality channels define a vent or a plurality of vents configured to expose the cavity of the semiconductor package to ambient air or other media exterior the semiconductor package.

In some aspects, the techniques described herein relate to a method, further including dispensing adhesive on a portion of the top surface of the plurality of walls of the body portion before the mounting of the bottom surface of the package lid to the top surface of the plurality of walls of the body portion.

In some aspects, the techniques described herein relate to a method, further including dispensing the adhesive onto first areas of the top surface of the plurality of walls of the body portion that align with areas of the bottom surface of the package lid where no channels are formed.

In some aspects, the techniques described herein relate to a method, further including dispensing adhesive onto second areas of the top surface of the plurality of walls of the body portion that align with areas of the bottom surface of the package lid to include one channel of the first plurality of channels.

In some aspects, the techniques described herein relate to a method, further including: before mounting the bottom surface of the package lid to the top surface of the plurality of walls of the body portion, forming a second channel or a second plurality of channels in the top surface of the plurality of walls of the body portion.

In some aspects, the techniques described herein relate to a method, further including aligning the first channel or the first plurality of channels of the bottom surface of the package lid to the second channel or the second plurality of channels of the top surface of the plurality of walls of the body portion when mounting the package lid to the body portion.

In some aspects, the techniques described herein relate to a method, further including forming the second channel or the second plurality of channels by molding, stamping, or sawing the top surface of the plurality of walls.

In some aspects, the techniques described herein relate to a method, further including forming the first channel or the first plurality of channels by molding, stamping, or sawing the lid.

In some aspects, the techniques described herein relate to a method, further including disposing a pressure sensitive gel in the cavity over the semiconductor die.

In some aspects, the techniques described herein relate to a method, further including forming the first channel or the first plurality of channels in the package lid to a length greater than a width of a first wall of the plurality of walls.

In some aspects, the techniques described herein relate to a semiconductor device including: a semiconductor die mounted on a substrate; a body portion of a semiconductor package including a plurality of walls configured to encapsulate the substrate wherein the plurality of walls of the body portion define a cavity; and a package lid having a first channel or a first plurality of channels formed in a bottom surface of the package lid, wherein the bottom surface of the package lid is mounted to a top surface of the body portion of the semiconductor package and the first channel or the first plurality of channels define a vent or a plurality of vents that exposes the cavity of the semiconductor package to ambient air and other media exterior the semiconductor package.

In some aspects, the techniques described herein relate to a semiconductor device, wherein a second channel or a second plurality of channels are formed in the top surface of the body portion of the semiconductor package.

In some aspects, the techniques described herein relate to a semiconductor device, wherein the first channel of the bottom surface of the package lid align with the second channel of the top surface of the plurality of walls of the body portion or the first plurality of channels of the bottom surface of the package lid align with the second plurality of channels of the top surface of the plurality of walls of the body portion when the package lid is mounted to the body portion.

In some aspects, the techniques described herein relate to a semiconductor device, wherein adhesive is disposed between the bottom surface of the package lid to the top surface of the body portion of the semiconductor package.

In some aspects, the techniques described herein relate to a semiconductor device, wherein the adhesive fills one of the first channel or the first plurality of channels.

In some aspects, the techniques described herein relate to a semiconductor device, wherein the first channel or the first plurality of channels are formed by either molding, stamping, or sawing.

In some aspects, the techniques described herein relate to a semiconductor device, further including a pressure sensitive gel in the cavity.

In some aspects, the techniques described herein relate to a semiconductor device, wherein the first channel or the first plurality of channels in the package lid are a length greater than a thickness of the top surface of the body portion.

In some aspects, the techniques described herein relate to a semiconductor package including: a semiconductor die mounted to a substrate; an encapsulant over the substrate and a portion of the semiconductor die, wherein the encapsulant is a body portion of the semiconductor package, wherein the body portion includes a plurality of walls defining a cavity; pressure sensitive gel in the cavity; and a package lid having a bottom surface that is non-planar, wherein the package lid is mounted to a top surface of the body portion of the semiconductor package and the non-planar bottom surface of the package lid defines a number of vents between the package lid and the top surface of the body portion that form a plurality of vents in fluid communication between the cavity and an exterior of the semiconductor package. In some aspects, the techniques described herein relate to a semiconductor package, wherein the top surface of the body portion of the semiconductor package is non-planar. While at least one exemplary embodiment has been presented in the foregoing detailed description, it should be appreciated that a vast number of variations exist. It should be appreciated that while two die are described in the exemplary embodiments, the invention considers embodiments where there are more or less semiconductor die in any configuration of those die. Additionally, the invention can apply to various semiconductor package embodiments, including the cavity package described and to other known sensor device packages. The innovation is not intended to be limited to pressure sensor devices and can apply to various types of sensors. It should be understood that various changes can be made in the function and arrangement of elements without departing from the scope defined by the claims, which includes known equivalents and foreseeable equivalents at the time of filing this patent application.

## Claims

1. A method of manufacturing a semiconductor package, comprising:
mounting a semiconductor die to a substrate;
forming encapsulant over the substrate to form a body portion of the semiconductor package, wherein the body portion includes a plurality of walls defining a cavity;
providing a package lid, wherein the package lid includes a first channel or a first plurality of channels formed in a bottom surface of the package lid; and
mounting the bottom surface of the package lid to a top surface of the plurality of walls of the body portion, wherein the first channel or the first plurality channels define a vent or a plurality of vents configured to expose the cavity of the semiconductor package to ambient air or other media exterior the semiconductor package.

2. The method of claim 1, further comprising dispensing adhesive on a portion of the top surface of the plurality of walls of the body portion before the mounting of the bottom surface of the package lid to the top surface of the plurality of walls of the body portion.

3. The method of claim 2, further comprising dispensing the adhesive onto first areas of the top surface of the plurality of walls of the body portion that align with areas of the bottom surface of the package lid where no channels are formed.

4. The method of claim 2 or claim 3, further comprising dispensing adhesive onto second areas of the top surface of the plurality of walls of the body portion that align with areas of the bottom surface of the package lid to include one channel of the first plurality of channels.

5. The method according to any preceding claim, further comprising:
before mounting the bottom surface of the package lid to the top surface of the plurality of walls of the body portion, forming a second channel or a second plurality of channels in the top surface of the plurality of walls of the body portion.

6. The method of claim 5, further comprising aligning the first channel or the first plurality of channels of the bottom surface of the package lid to the second channel or the second plurality of channels of the top surface of the plurality of walls of the body portion when mounting the package lid to the body portion.

7. The method of claim 5, further comprising forming the second channel or the second plurality of channels by molding, stamping, or sawing the top surface of the plurality of walls.

8. The method according to any preceding claim, further comprising forming the first channel or the first plurality of channels by molding, stamping, or sawing the lid.

9. The method according to any preceding claim, further comprising disposing a pressure sensitive gel in the cavity over the semiconductor die.

10. The method according to any preceding claim, further comprising forming the first channel or the first plurality of channels in the package lid to a length greater than a width of a first wall of the plurality of walls.

11. A semiconductor device comprising:
a semiconductor die mounted on a substrate;
a body portion of a semiconductor package including a plurality of walls configured to encapsulate the substrate wherein the plurality of walls of the body portion define a cavity; and
a package lid having a first channel or a first plurality of channels formed in a bottom surface of the package lid, wherein the bottom surface of the package lid is mounted to a top surface of the body portion of the semiconductor package and the first channel or the first plurality of channels define a vent or a plurality of vents that exposes the cavity of the semiconductor package to ambient air and other media exterior the semiconductor package.

12. The semiconductor device of claim 11, wherein a second channel or a second plurality of channels are formed in the top surface of the body portion of the semiconductor package.

13. The semiconductor device of claim 12, wherein the first channel of the bottom surface of the package lid align with the second channel of the top surface of the plurality of walls of the body portion or the first plurality of channels of the bottom surface of the package lid align with the second plurality of channels of the top surface of the plurality of walls of the body portion when the package lid is mounted to the body portion.

14. The semiconductor device according to any of claim 11 to claim 13, wherein adhesive is disposed between the bottom surface of the package lid to the top surface of the body portion of the semiconductor package.

15. The semiconductor device of claim 14, wherein the adhesive fills one of the first channel or the first plurality of channels.
